Europäisches Patentamt

European Patent Office

Office européen des brevets

(11) Veröffentlichungsnummer : **0 355 508 B1**

(12) # EUROPÄISCHE PATENTSCHRIFT

(45) Veröffentlichungstag der Patentschrift :
**27.12.95 Patentblatt 95/52**

(51) Int. Cl.$^6$ : **G01R 33/54**, G01F 1/56

(21) Anmeldenummer : **89114282.0**

(22) Anmeldetag : **02.08.89**

(54) **Pulssequenz zur Messung des zeitlichen Verlaufs eines Flusses in einem Gefäss mit Hilfe der magnetischen Resonanz**

(30) Priorität : **16.08.88 DE 3827800**

(43) Veröffentlichungstag der Anmeldung :
**28.02.90 Patentblatt 90/09**

(45) Bekanntmachung des Hinweises auf die
Patenterteilung :
**27.12.95 Patentblatt 95/52**

(84) Benannte Vertragsstaaten :
**DE GB**

(56) Entgegenhaltungen :
**EP-A- 0 191 431**
**EP-A- 0 267 375**
**MAGNETIC RESONANCE IN MEDICINE, Band
7, Nr. 1, Mai 1988, Seiten 79-87, Duluth, MN,
US; J. FRAHM et al.: "Rapid line scan NMR
angiography"**

(56) Entgegenhaltungen :
**JOURNAL OF COMPUTER ASSISTED TOMO-
GRAPHY, Band 10, Nr. 5, September 1986,
Seiten 715-722, New York, US; G.L. NAYLER et
al.: "Blood flow imaging by cine magnetic
resonance"**
**IEEE TRANSACTIONS ON MEDICAL IMA-
GING, Band MI-5, Nr. 3, September 1986, Seiten 140-151, New York, US; D.G. NISHIMURA
et al.: "Magnetic resonance angiography"**

(73) Patentinhaber : **SIEMENS
AKTIENGESELLSCHAFT
Wittelsbacherplatz 2
D-80333 München (DE)**

(72) Erfinder : **Müller, Edgar, Dipl.-Phys.
Klingenstrasse 5
D-8551 Heroldsbach (DE)**
Erfinder : **Laub, Gerhard, Dr.
Adelsgasse 32
D-8551 Heroldsbach (DE)**

## Beschreibung

Es ist eine Reihe von Verfahren bekannt, mit Hilfe der magnetischen Resonanz eine Flußmessung durchzuführen. Diese beruhen zum Teil darauf, daß eine Schicht eines Untersuchungsobjektes, die möglichst senkrecht zur Flußrichtung steht, selektiv angeregt wird. Während der Brenndauer des Schichtselektionsgradienten wird bewegten Spins eine zusätzliche Phase aufgeprägt, durch deren Auswertung man eine Information über den Fluß erhalten kann.

Durch Aufschaltung weiterer Gradienten kann man auch ein Bild des Untersuchungsobjektes darstellen, in dem ein Fluß abgebildet wird. Eine derartige Methode ist beispielsweise aus dem "Journal of Computer Assisted Tomography" 10 (5), Seiten 715-722, 1986 bekannt. Hierbei werden - wie bei üblichen Bildgebungsverfahren - drei senkrecht aufeinanderstehende Gradienten, nämlich ein Schichtselektionsgradient, ein Read-Gradient und ein Phasencodiergradient verwendet. Der Phasencodiergradient wird wie beim üblichen Spin Warp-Verfahren von Scan zu Scan weitergeschaltet, so daß man eine volle Ortsauflösung erzielt. Allerdings ist die Darstellung des zeitlichen Verlaufs eines Flusses nur mit relativ langen Untersuchungszeiten möglich.

Aus der EP 0 267 375 AI ist ein Verfahren zum Bestimmen von beweglichem Material bekannt, bei dem bei einem Spin-warp-Verfahren die Phasencodierung weggelassen wird und stattdessen ein Geschwindigkeitscodiergradient von Zeile zu Zeile einer Rohdatenmatrix fortgeschaltet wird. Damit erhält man ein Bild, bei dem die örtliche Abhängigkeit des Flusses dargestellt ist. Die Zeitabhängigkeit kann durch Aneinanderreihung mehrerer getriggerter Bilder dargestellt werden.

Aus der Zeitschrift "Magnetic Resonance in Medicine", 7 (1988), Seiten 79 bis 87, ist ein Angiographieverfahren bekannt, bei dem ein Bild aus einzelnen Linienprojektionen zusammengesetzt wird. Durch Zusammensetzung mehrerer getriggerter Bilder können Filmaufnahmen, die den zeitlichen Ablauf des Flusses darstellen, gewonnen werden.

Die Darstellung des zeitlichen Verlaufs eines Flusses ist von hohem diagnostischen Wert. Bei herkömmlichen Verfahren kann dieser Verlauf nur durch EKG-Triggerung dargestellt werden, was jedoch gegenüber einer Echtzeitdarstellung weniger aussagekräftig und zeitaufwendig ist.

Aufgabe der Erfindung ist es, eine Pulssequenz zur Messung des zeitlichen Verlaufs eines Flusses in einem Gefäß so auszugestalten, daß eine Echtzeitdarstellung des Flusses bei ausreichender örtlicher Lokalisierung ermöglicht wird.

Diese Aufgabe wird erfindungsgemäß gelöst durch die Merkmale des Patentanspruchs 1. Vorteilhafte Ausgestaltungen der Erfindung sind in den Unteransprüchen angegeben.

Ein Ausführungsbeispiel wird nachfolgend anhand der Figuren 1 bis 29 näher erläutert. Dabei zeigt:

FIG 1       den schematischen Aufbau eines Kernspin-Tomographiegerätes,
FIG 2-5       ein erstes Ausführungsbeispiel einer Pulssequenz gemäß der Erfindung,
FIG 6-10       ein zweites Ausführungsbeispiel für eine Pulssequenz gemäß der Erfindung,
FIG 11-17       ein drittes Ausführungsbeispiel für eine Pulssequenz gemäß der Erfindung,
FIG 18       den Verlauf eines linearen Gradienten,
FIG 19       den Verlauf des Kernresonanzsignals S in Abhängigkeit von der Phase für einen linearen Gradienten,
FIG 20       den Verlauf eines quadratischen Gradienten,
FIG 21       den Verlauf des Kernresonanzsignals bei einem quadratischen Gradienten,
FIG 22       die Anordnung von Bändern B zur Feldverzerrung,
FIG 23 bis 28       ein viertes Ausführungsbeispiel für eine Pulssequenz gemäß der Erfindung,
FIG 29       beispielhaft den zeitlichen Verlauf eines Flusses, wie er nach dem beschriebenen Verfahren erhalten wird.

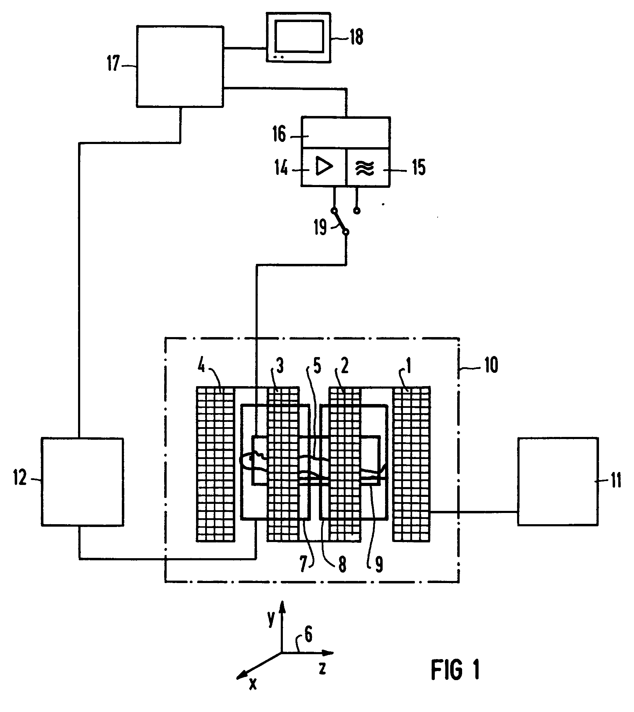

FIG 1 zeigt schematisch den prinzipiellen Aufbau eines Kernspin-Tomographiegerätes zur Erstellung von Bildern eines Untersuchungsobjektes und zur Messung des zeitlichen Verlaufs des Flusses in Gefäßen des Untersuchungsobjektes. Die Spulen 1 bis 4 erzeugen ein magnetisches Grundfeld $B_0$, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldkomponenten der Richtungen x, y und z gemäß dem Koordinatenkreuz 6 vorgesehen sind. In der FIG sind der Übersichtlichkeit halber nur die Gradientenspulen 7 und 8 gezeichnet, die zusammen mit einem Paar gegenüberliegender, gleichartiger Gradientenspulen zur Erzeugung eines X-Gradienten dienen. Die gleichartigen, nicht in gezeichneten Y-Gradientenspulen liegen parallel zum Körper 5 und oberhalb sowie unterhalb von ihm, die für das Z-Gradientenfeld quer zu seiner Längsachse am Kopf- und am Fußende.

Die Anordnung erhält außerdem noch eine zur Erzeugung und Aufnahme der Kernresonanzsignale dienende Hochfrequenzspule 9. Die von einer strichpunktierten Linie 10 umgrenzten Spulen 1, 2, 3, 4, 7, 8 und 9 stellen das eigentliche Untersuchungsinstrument dar.

Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die Hochfrequenzspule 9 ist über einen Signalverstärker 14 bzw. einen Hochfrequenzsender 15 an einen Prozeßrechner 17 gekoppelt, an dem zur Ausgabe der Abbildung ein Bildschirmgerät 18 angeschlossen ist. Die Komponenten 14 und 15 bilden eine Hochfrequenzeinrichtung 16 zur Signalerzeugung und -aufnahme. Ein Umschalter 19 ermöglicht das Umschalten von Sende- auf Empfangsbetrieb.

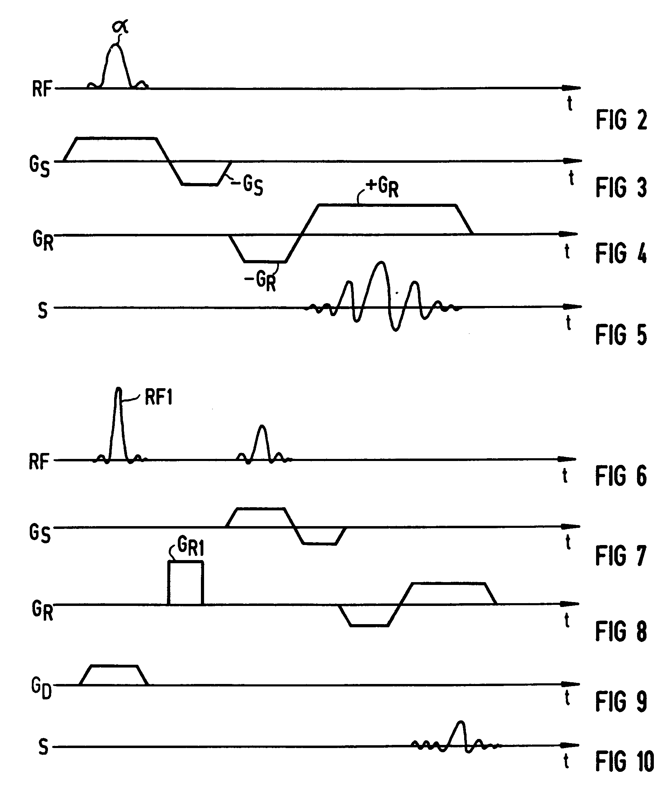

Die erfindungsgemäße Pulssequenz wird anhand eines Ausführungsbeispiels im folgenden anhand der FIG 2-5 näher erläutert. Wenn der Fluß in einem bestimmten Gefäß, z.B. in der Aorta oder in der vena cava eines Patienten untersucht werden soll, so wird zunächst eine Schicht senkrecht zur Hauptflußrichtung dieses Gefäßes mit einem in FIG 2 dargestellten frequenzselektiven Hochfrequenzimpuls RF angeregt. Der Hochfrequenzimpuls RF wird dadurch schichtselektiv, daß gleichzeitig ein Schichtselektionsgradient $G_S$ aufgeschaltet wird, so daß die durch die Larmor-Gleichung gegebene Resonanzbedingung nur für eine gewisse Schicht senkrecht zur Richtung des Schichtselektionsgradienten $G_S$ erfüllt ist. Der Schichtselektionsgradient kann durch gleichzeitige Aufschaltung von Gradienten in x-, y- und z-Richtung in beliebiger Richtung gewählt werden.

Die Flußmessung beruht nun darauf, daß einem fließenden Spinsystem während der Brenndauer des Schichtselektionsgradienten $G_S$ senkrecht zur angeregten Schicht eine zusätzliche Phase der Flußphase $\phi$ (v, t, $G_S$) aufgeprägt wird. Dabei ist v die Flußgeschwindigkeit und t die Zeit. Ferner gelangen nichtangeregte Spins in die selektierte Schicht, was allgemein als "inflow" bezeichnet wird.

Die Flußphase $\phi$ (v, t, $G_S(t)$) ergibt sich aus folgender Gleichung:

$$\phi\ (v,\ t,\ G_S(t))\ =\ \chi\ \cdot\ \int_0^t\ G_S\ (t')\ \cdot\ t'\ \cdot\ v\ (t')\ \cdot\ d\ t'$$

Wenn die Geschwindigkeitsänderung während der Brenndauer der Schichtselektionsgradienten $G_S$ klein ist, kann v vor das Integral gezogen werden. Die eigentlich interessierende Flußphase zum Zeitpunkt $t_o$ bei Abschluß des Schichtselektionsgradienten wird im folgenden als $\phi$ (v, $t_o$) bezeichnet.

Nach Abschluß des Hochfrequenzimpulses RF wird die durch den Schichtselektionsgradienten $G_S$ verursachte Dephasierung des Spinsystems durch Umkehr dieses Schichtselektionsgradienten wieder rephasiert. Anschließend wird ein negativer Read-Gradient $-G_R$ aufgeschaltet (FIG 4), der senkrecht zur Richtung des Schichtselektionsgradienten $G_S$ steht. Damit wird eine Dephasierung des Spinsystems in Richtung des Read-Gradienten $G_R$ bewirkt. Durch Umschalten auf einen positiven Read-Gradienten $G_R$ wird das Spinsystem wieder rephasiert, so daß ein in FIG 5 dargestelltes Spinecho S entsteht.

Da während des Auslesens des Spinechos S der Read-Gradient $+G_R$ eingeschaltet ist, wird eine Ortscodierung in Richtung dieses Gradienten durchgeführt. Die Hüllkurve des Spinechosignals S hängt von der Geometrie des Untersuchungsobjektes 5 ab. Die Spinecho-Hüllkurve kann im stationären Zustand als F(t) beschrieben werden. Das entstehende Signal wird mit einem Quadratur-Detektor phasenempfindlich detektiert. Für das mit der Geschwindigkeit v in Richtung des Selektionsgradienten $G_S$ bewegte Medium gilt für den Realteil SR(t) des Spinechosignals S(t) und den Imaginärteil SJ(t) folgendes:

$$SR(t)\ =\ F(t)\ \cdot\ \exp\ (i\ \cdot\ \phi\ (v,\ t,\ G_S(t_o))$$
$$SJ(t)\ =\ SR(t)\ \cdot\ e^{i\pi/2}$$

Aufgrund von nicht angeregten Spins, die während der Repetitionszeit $T_R$ in die selektierte Schicht wandern, wird auch der Betrag des Spinechosignals in Abhängigkeit von der Geschwindigkeit des fließenden Mediums verändert. Auch diese Betragsänderung läßt sich zur Ermittlung der Flußgeschwindigkeit ausnutzen.

Die dargestellte Pulssequenz wird nun beliebig oft, z.B. n-mal wiederholt. Damit besteht eine gewisse Ähnlichkeit mit dem herkömmlichen Spin Warp-Verfahren oder auch mit dem Flash-Verfahren, wie es beispielsweise in der EP-A2-0 191 431 dargestellt ist. Diese genannten Verfahren dienen jedoch zur Bilderzeugung mit dreidimensionaler Auflösung. Bei der vorliegenden Pulssequenz zur Messung des zeitlichen Verlaufs eines Flusses wird im Gegensatz zu den genannten Verfahren kein sogenannter Phasencodiergradient eingeführt, so daß auf eine Ortsauflösung in drei Dimensionen verzichtet wird. Vielmehr lassen sich die gewonnenen Daten als eine Projektion in Richtung des sonst üblichen Phasencodiergradienten interpretieren.

Die Ortsauflösung in Richtung des sonst vorhandenen Phasencodiergradienten wird hier zu Gunsten einer zeitlichen Auflösung des Flusses eingetauscht.

Jedes ausgelesene Spinecho birgt nun nach den obigen Ausführungen unmittelbar eine Flußinformation in sich. Jedes Spinecho wird digitalisiert und als Zeile in eine Rohdatenmatrix geschrieben. Durch Fouriertransformation jeder Zeile kann die Flußinformation in Richtung des Read-Gradienten $G_R$ ortsaufgelöst werden. Selbstverständlich muß darauf geachtet werden, daß in der zu Read-Gradienten $G_R$ und Schichtselektionsgradienten $G_S$ senkrechten Richtung, in der keine Ortsauflösung, sondern eine Projektion vorliegt, nicht mehrere Gefäße hintereinander liegen. Im allgemeinen läßt sich das jedoch problemlos erreichen.

In der Regel setzt sich das Spinechosignal aus Signalbeiträgen aus dem interessierenden Gefäß (fließendem Blut) sowie aus Beiträgen von Gewebe, das in Richtung senkrecht zu $G_S$ und $G_R$ oberhalb und unterhalb des Gefäßes liegt, zusammen, da ja auf eine Ortsauflösung in dieser Richtung verzichtet wurde. Die unerwünschten Signalbeiträge von stationärem Gewebe können durch unterschiedliche Maßnahmen eliminiert werden. Unter Umständen reicht schon eine günstige Parameterwahl der Repetitionszeit und des Flipwinkels aus, da hiermit erreicht werden kann, daß Blut als Flüssigkeit mit hohem Kontrast zu umgebendem Gewebe abgebildet wird. Eine weitere Möglichkeit der Reduktion unerwünschter Signalbeiträge von stationärem Gewebe ist in einem Ausführungsbeispiel einer Pulssequenz gemäß den FIG 6 bis 10 dargestellt. Diese Pulssequenz unterscheidet sich von der bereits besprochenen dadurch, daß ein Hochfrequenzimpuls $RF_1$ als Sättigungsimpuls vorangestellt wird. Durch gleichzeitiges Aufschalten eines Gradienten $G_D$ senkrecht zu den Gradienten $G_S$ und $G_R$ wirkt der Sättigungsimpuls selektiv auf eine Schicht senkrecht zur $G_D$-Richtung. Diese Schicht wird so gewählt, daß das gewünschte Gefäß gerade ausgespart wird. Voraussetzung ist hierbei natürlich, daß das Gefäß nicht in $G_D$-Richtung abbiegt. Zusätzlich kann noch ein Spoilergradient $G_{R1}$ zur Zerstörung der Magnetisierung angewandt werden.

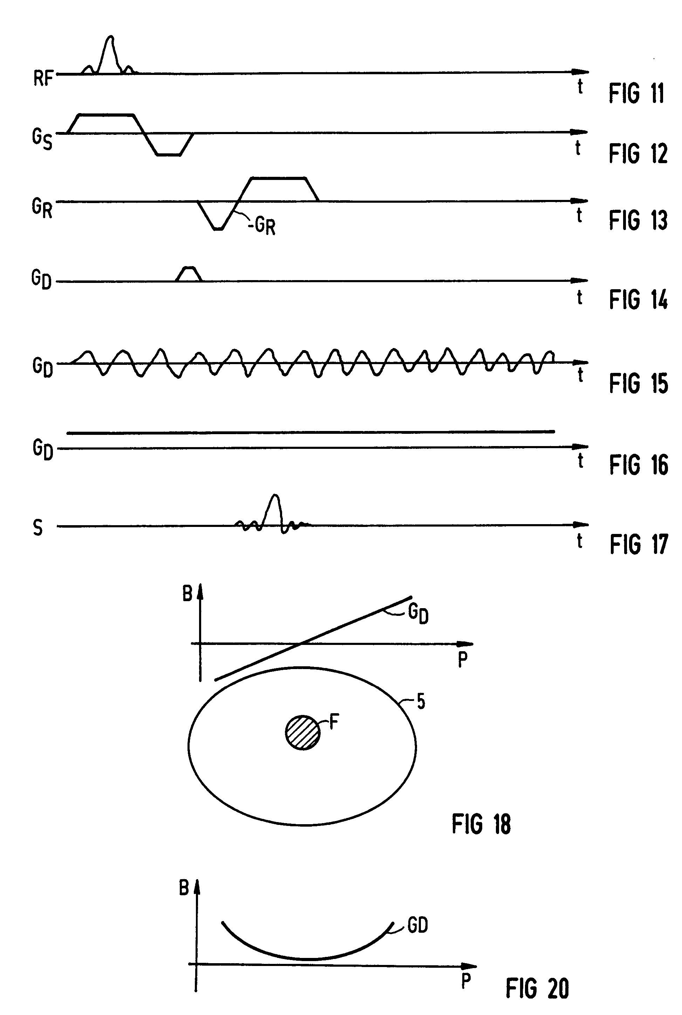

Eine weitere Möglichkeit zur Reduzierung der Signalbeiträge von stationärem Gewebe ist in einer Pulsfolge gemäß den FIG 11 bis 17 dargestellt. Diese Pulssequenz unterscheidet sich von der Pulssequenz nach den FIG 2 bis 5 dadurch, daß entweder in einer ersten Variante nach FIG 14 nach dem Schichtselektionsgradienten $G_S$ ein zum Schichtselektionsgradienten $G_S$ und zum Read-Gradienten $G_R$ senkrechter Gradient $G_D$ eingeschaltet wird oder in einer zweiten Variante während der gesamten Pulssequenz ein oszillierender Gradient $G_D$ gemäß FIG 15 angelegt wird. Eine weitere Möglichkeit besteht darin, während der gesamten Pulssequenz einen zeitlich konstanten Gradienten gemäß Fig. 16 einzuschalten. Dabei wird, wie in FIG 18 dargestellt, der Gradient $G_D$ in jedem Fall so gewählt, daß das Gefäß F in dem Bereich liegt, in dem der Gradient $G_D$ die Null-Linie schneidet, d.h. das Grundfeld B nicht beeinflußt. Damit werden die Spins im Gewebe außerhalb des Gefäßes dephasiert und tragen somit nicht zum Signal bei.

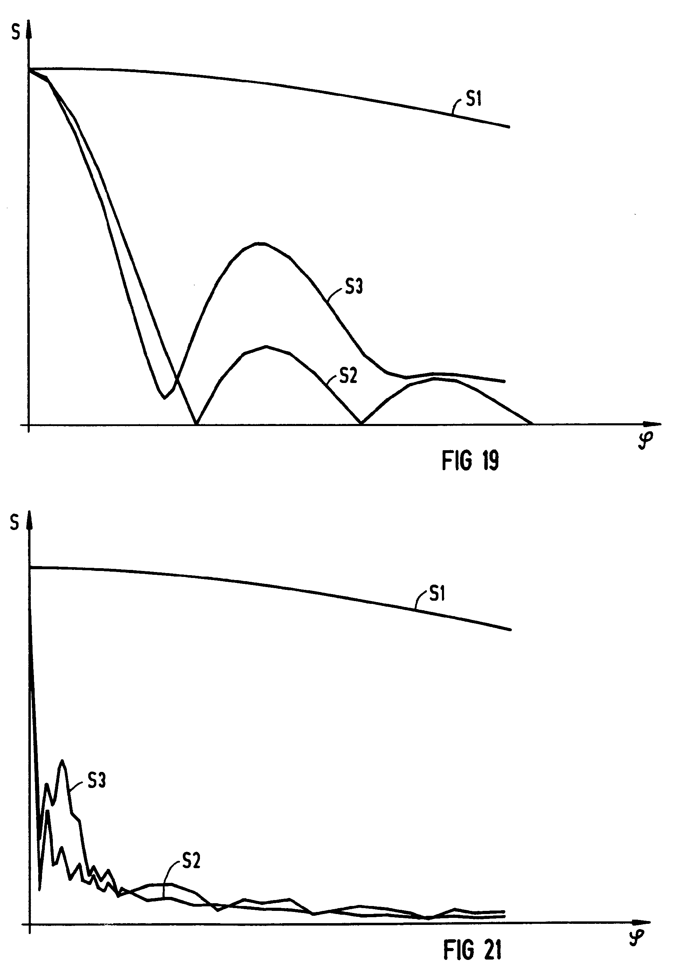

In FIG 19 ist die Signalabschwächung durch den besprochenen linearen Gradienten $G_D$ dargestellt. Dabei zeigt FIG 19 den Verlauf der Signalamplitude S über den Phasenwinkel $\varphi$. Dabei ist die durch den Gradienten $G_D$ über die gesamte Projektion verursachte Phasendrehung. Mit $S_1$ ist dabei das Signal aus dem Gefäß F bezeichnet, mit $S_2$ das Signal aus dem stationären Gewebe, wobei eine homogene Spindichte in diesem Gewebe vorausgesetzt ist, mit $S_3$ ebenfalls das Signal aus dem stationären Gewebe, in diesem Fall jedoch bei inhomogener Spindichte.

Eine weitere Verringerung der Signalanteile aus stationärem Gewebe kann erreicht werden, indem man den Gradienten $G_D$ nicht linear ausführt, sondern in einer Funktion höherer Ordnung, z.B. einer quadratischen Funktion, wie in FIG 20 dargestellt. Der damit erzielte Verlauf von Signalen aus dem Gefäß ($S_1$) und aus stationärem Gewebe ist in FIG 21 dargestellt. Dabei ist mit $S_2$ wieder der Signalverlauf bei homogener Spindichte und mit $S_3$ der Signalverlauf bei inhomogener Spindichte dargestellt.

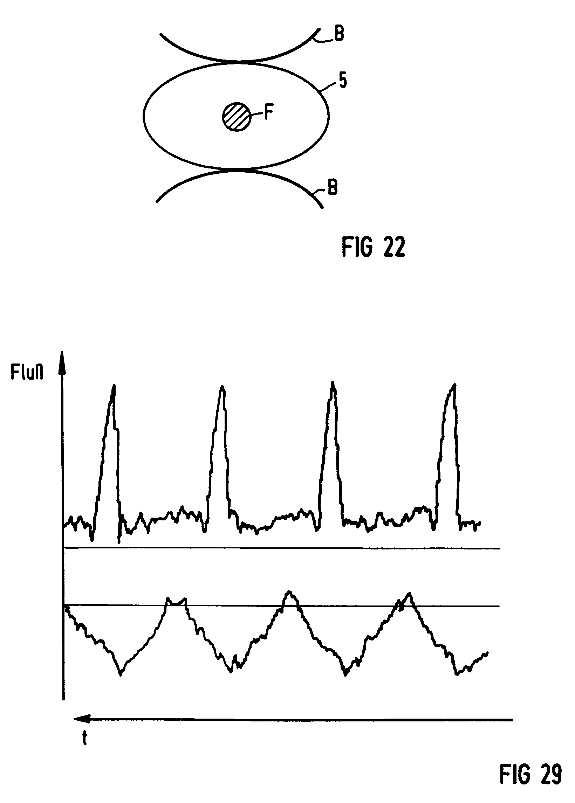

Eine Reduzierung der Signalanteile aus stationärem Gewebe kann schließlich auch dadurch erreicht werden, daß man - wie in FIG 22 dargestellt - an das Untersuchungsobjekt 5 ferromagnetische Teile, z.B. Bänder B, anlegt, die zu einer Feldverzerrung außerhalb des Gefäßes F führen. Damit werden die Spins außerhalb des Gefäßes F dephasiert und somit deren Signalbeitrag verringert.

Wenn der betrachtete Fluß Bewegungskomponenten aufweist, die nicht senkrecht zur selektierten Schicht verlaufen, wird über den Read-Out-Gradienten $G_R$ nach Fig. 13 eine zusätzliche Phase erzeugt, die unter Umständen zu einem nicht vernachlässigbaren Fehler führt. Die Kompensation dieses Fehlers bei der Berechnung von Flußgeschwindigkeiten wäre zwar im Prinzip möglich, würde aber voraussetzen, daß der Untersuchende die Abweichung der Flußrichtung vom Schichtnormal aufgrund einer Bildinformation ausmißt und dem Rechner vorgibt.

Es ist zwar grundsätzlich möglich, Schichten beliebig im Raum und damit senkrecht zu einem Gefäß zu orientieren. Wenn jedoch Flußgeschwindigkeiten in mehreren, nicht parallel verlaufenden Gefäßen simultan gemessen werden sollen, tritt zwangsläufig eine Abweichung von der Flußrichtung von der Schichtnormalen auf. Mit der nachfolgend beschriebenen Einführung eines Flußrephasiergradienten $G_{RF}$ in Read-Out-Richtung führen Abweichungen von der Schichtnormalen innerhalb gewisser Grenzen (z.B. 10°) nur zu vernachlässigbar kleinen Fehlern.

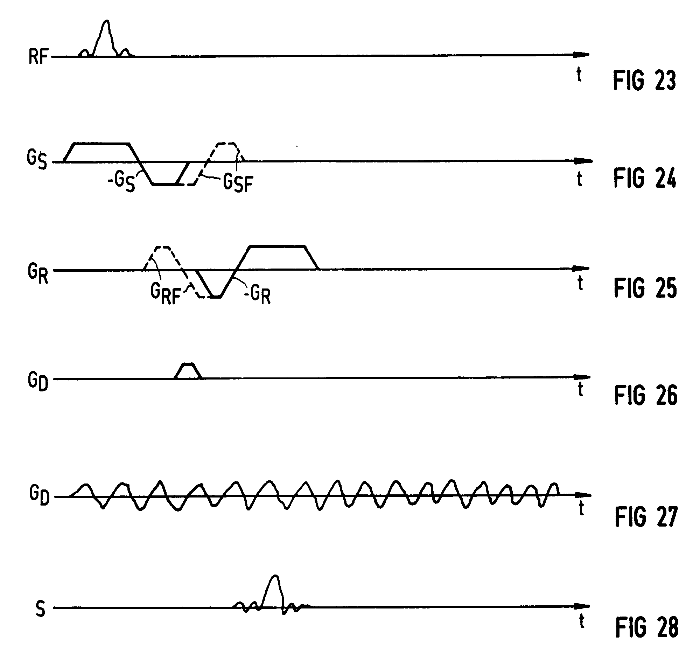

Eine Pulssequenz mit einem derartigen Flußrephasier-Gradienten $G_{RF}$ ist in den FIG 23 bis 28 dargestellt. Im übrigen entspricht die Pulssequenz der in den FIG 11 bis 17 dargestellten.

Der Flußrephasiergradient $G_{RF}$ ist ein bipolarer Gradient, der gemäß FIG 25 dem Vordephasiergradienten -$G_R$ vorangestellt wird. Die Polarität des Flußrephasiergradienten $G_{RF}$ wechselt von Plus nach Minus. Das Amplituden-Zeitintegral über dem Flußrephasiergradienten $G_{RF}$ ist Null, so daß stationäre Spins nicht beeinflußt werden. Bei richtiger Wahl von Amplitude und zeitlichem Verlauf des Flußrephasiergradienten $G_{RF}$ werden alle in Read-Out-Richtung gleichförmig bewegten Spins zum Echozeitpunkt rephasiert, so daß eine Bewegung in Read-Out-Richtung - wie gewünscht - keine zusätzliche Flußphase verursacht.

Der Flußrephasiergradient wird entsprechend der bereits eingangs genannten Literaturstelle "Journal of Computer Assisted Tomography" 10 (5), Seiten 715-722, Sept./Oct. 1986 so dimensioniert, daß gilt:

$$\phi_v(t) = \gamma \cdot v' \cdot \int_0^t G_R(t') \cdot t' \, dt' = 0$$

Der negative Teil des Flußrephasiergradienten $G_{RF}$ kann mit dem Vordephasiergradienten -$G_R$ zu einem Gradientenpuls zusammengefaßt werden.

Zur Bewertung der Flußgeschwindigkeit benötigt man eine Nulllinie. Das kann z.B. durch Messung einer dem Gefäß benachbarten Projektion, die keine bewegten Spins enthält, erfolgen. Alternativ kann man auch, wie in FIG 24 gestrichelt eingezeichnet, eine Flußkompensation durch einen bipolaren, dem Rephasiergradienten -$G_S$ nachgeschalteten Flußrephasiergradienten $G_{SF}$ in Schichtselektionsrichtung erreichen. Auch hierbei gilt wieder die Forderung, daß das Amplituden-Zeitintegral über dem Flußrephasiergradienten Null sein muß. Dabei kann die Sequenz mit Flußrephasierung in Schichtselektionsrichtung entweder einer vollständigen Flußmessung vorangestellt oder mit dieser verschachtelt werden, wobei dann die Sequenz mit dem Flußrephasiergradienten $G_{SF}$ und ohne den Flußrephasiergradienten $G_{SF}$ alternierend durchgeführt wird.

In FIG 29 ist der mit dem beschriebenen Verfahren dargestellte Verlauf des Blutflusses in der Aorta (obere Kurve) und der Verlauf des Blutflusses in der vena cava (untere Kurve) eines Probanden dargestellt.

**Patentansprüche**

1. Verfahren zur Echtzeitmessung des zeitlichen Verlaufs eines Flusses in einem Gefäß eines Untersuchungsobjektes mit Hilfe der magnetischen Resonanz mit folgenden Schritten:
   a) durch gleichzeitige Aufschaltung eines frequenzselektiven Hochfrequenzimpulses (RF) und eines Schichtselektionsgradienten ($G_S$) in einer ersten Richtung wird eine Schicht des untersuchungsobjektes selektiv angeregt, zu der der Fluß eine senkrechte Komponente aufweist;
   b) es wird ein Echosignal (S) des resultierenden Kernspinresonanzsignals der angeregten Schicht erzeugt;
   c) unter der Einwirkung eines zum Schichtselektionsgradienten ($G_S$) senkrecht stehenden Read-Gradienten ($G_R$) in einer zweiten Richtung wird das Echosignal (S) ausgelesen;
   d) die bei n unmittelbar aufeinanderfolgenden Wiederholungen der Schritte a)-c) gewonnenen Echosignale werden einer Fouriertransformation in Richtung des Read-Gradienten unterworfen, und aus den fouriertransformierten Signalen wird jeweils eine über die Signalbeiträge in der zur ersten und zweiten Richtung senkrechten Richtung gemittelte Flußgeschwindigkeit ermittelt, die in Form eines Flußgeschwindigkeits-Zeit-Diagramms dargestellt wird.

2. Verfahren nach Anspruch 1, **dadurch gekennzeichnet**, daß das Echosignal (S) dadurch erzeugt wird, daß dem Read-Gradienten ($G_R$) ein Vordephasiergradient (-$G_R$) in entgegengesetzter Richtung vorgeschaltet wird.

3. Verfahren nach Anspruch 2, **dadurch gekennzeichnet**, daß dem Vordephasiergradienten (-$G_R$) ein bipolarer Gradient ($G_{RG}$) zur Flußrephasierung vorgeschaltet ist.

4. Verfahren nach einem der Ansprüche 1 bis 3, **dadurch gekennzeichnet**, daß auf den Schichtselektionsgradienten ($G_S$) ein diesem entgegengesetzt gerichteter Rephasiergradient (-$G_S$) folgt.

5. Verfahren nach Anspruch 4, **dadurch gekennzeichnet**, daß auf den Rephasiergradienten (-$G_S$) bei mindestens einem Scan je Flußmessung ein bipolarer Flußrephasiergradient ($G_{SF}$) folgt.

6. Verfahren nach einem der Ansprüche 1 bis 5, **dadurch gekennzeichnet**, daß Bereiche des Untersuchungsobjektes außerhalb des interessierenden Gefäßes (F) vor dem Schritt a) selektiv gesättigt werden.

7. Verfahren nach einem der Ansprüche 1 bis 6, **dadurch gekennzeichnet**, daß Kernspins außerhalb des interessierenden Gefäßes (F) durch Aufschaltung eines senkrecht zum Schichtselektionsgradienten ($G_S$) und zum Read-Gradienten ($G_R$) stehenden zweiten Dephasiergradienten ($G_D$) dephasiert werden, wobei der zweite Dephasiergradient ($G_D$) im Bereich des interessierenden Gefäßes (F) einen Nulldurchgang hat.

8. Verfahren nach Anspruch 7, **dadurch gekennzeichnet**, daß der zweite Dephasiergradient ($G_D$) vor dem ersten Dephasiergradienten ($-G_R$) angelegt wird.

9. Verfahren nach Anspruch 6, **dadurch gekennzeichnet**, daß der zweite Dephasiergradient ($G_D$) oszilliert.

## Claims

1. Method for real-time measurement of the temporal course of a flow in a vessel of an examination object with the aid of magnetic resonance, having the following steps:
   a) with simultaneous application of a frequency-selective high-frequency pulse (RF) and a layer selection gradient ($G_S$) in a first direction a layer of the examination object to which the flow has a perpendicular component is selectively excited;
   b) an echo signal (S) of the resulting nuclear spin resonance signal of the excited layer is generated;
   c) under the action of a read gradient ($G_R$) perpendicular to the layer selection gradient ($G_S$) in a second direction the echo signal (S) is read out;
   d) the echo signal obtained with n directly successive repetitions of steps a) to c) are subjected to a Fourier transformation in the direction of the read gradient and from the fourier-transformed signals in each case there is determined a flow speed averaged by way of the signal contributions in the direction perpendicular to the first and the second direction, which flow speed is shown in the form of a flow speed time diagram.

2. Method according to claim 1, characterized in that the echo signal (S) is generated in that a predephasing gradient ($-G_R$) in the opposite direction precedes the read gradient ($G_R$).

3. Method according to claim 2, characterized in that a bipolar gradient ($G_{RG}$) precedes the predephasing gradient ($-G_R$) for the flow rephasing.

4. Method according to one of claims 1 to 3, characterized in that the layer selection gradient ($G_S$) is followed by a rephasing gradient ($-G_S$) oppositely directed thereto.

5. Method according to claim 4, characterized in that a bipolar flow rephasing gradient ($G_{SF}$) follows the rephasing gradient ($-G_S$) for at least one scan per flow measurement.

6. Method according to one of claims 1 to 5, characterized in that regions of the examination object outside the vessel (F ) of interest are selectively saturated before step a).

7. Method according to one of claims 1 to 6, characterized in that nuclear spins outside the vessel (F) of interest are dephased by application of a second dephasing gradient ($G_D$) perpendicular to the layer selection gradient ($G_S$) and to the read gradient ($G_R$), whereby the second dephasing gradient ($G_D$) has a zero crossing in the region of the vessel (F) of interest.

8. Method according to claim 7, characterized in that the second dephasing gradient ($G_D$) is applied before the first dephasing gradient ($-G_R$).

9. Method according to claim 6, characterized in that the second dephasing gradient ($G_D$) oscillates.

## Revendications

1. Procédé de mesure en temps réel de la courbe en fonction du temps d'un écoulement dans un vaisseau d'un objet à examiner à l'aide de la résonance magnétique, comportant les étapes suivantes :

a) on excite de manière sélective une couche de l'objet à examiner, par rapport à laquelle l'écoulement a une composante orthogonale, en introduisant en même temps une impulsion (RF) haute fréquence sélective en fréquence et un gradient ($G_S$) de sélection de couche dans une première direction ;

b) on produit un signal (S) d'écho du signal résultant de résonnance magnétique nucléaire de la couche excitée ;

c) on lit le signal (S) d'écho dans une seconde direction sous l'action d'un gradient ($G_R$) de lecture perpendiculaire au gradient ($G_S$) de sélection de couche ;

d) on soumet les signaux d'écho, obtenus en répétant directement les unes à la suite des autres les étapes a) à c), à une transformation de Fourier dans la direction du gradient de lecture et on détermine à partir des signaux transformés suivant la transformation de Fourier une vitesse d'écoulement, qui est prise en moyenne sur les contributions aux signaux dans la direction perpendiculaire à la première et à la seconde directions et que l'on représente sous forme d'un diagramme vitesse d'écoulement-temps.

2.  Procédé suivant la revendication 1, caractérisé en ce que l'on produit le signal (S) d'écho en mettant avant le gradient ($G_R$) de lecture un gradient (-$G_R$) de pré-déphasage en sens opposé.

3.  Procédé suivant la revendication 2, caractérisé en ce que l'on met avant le gradient (-$G_R$) de pré-déphasage un gradient ($G_{RG}$) bipolaire pour se remettre en phase avec l'écoulement.

4.  Procédé suivant l'une des revendications 1 à 3, caractérisé en ce que le gradient ($G_S$) de sélection de couche est suivi d'un gradient (-$G_S$) de remise en phase dirigé en sens opposé.

5.  Procédé suivant la revendication 4, caractérisé en ce qu'un gradient ($G_{SF}$) bipolaire de remise en phase avec l'écoulement suit le gradient (-$G_S$) de remise en phase pour au moins un balayage par mesure d'écoulement.

6.  Procédé suivant l'une des revendications 1 à 5, caractérisé en ce que l'on sature de manière sélective avant l'étape a) des domaines de l'objet à examiner en dehors du vaisseau (F) intéressant.

7.  Procédé suivant l'une des revendications 1 à 6, caractérisé en ce que l'on déphase des spins nucléaires en dehors du vaisseau (F) intéressant en introduisant un second gradient ($G_D$) de déphasage perpendiculaire au gradient ($G_S$) de sélection de couche et au gradient ($G_R$) de lecture, le second gradient ($G_D$) de déphasage passant par 0 dans la zone du vaisseau (F) intéressant.

8.  Procédé suivant la revendication 7, caractérisé en ce que l'on applique le second gradient ($G_D$) de déphasage avant le premier gradient (-$G_R$) de déphasage.

9.  Procédé suivant la revendication 6, caractérisé en ce que le second gradient ($G_D$) de déphasage oscille.

**FIG 1**

FIG 2

FIG 3

FIG 4

FIG 5

FIG 6

FIG 7

FIG 8

FIG 9

FIG 10

RF                                    t      **FIG 11**

$G_S$                                    t      **FIG 12**

$G_R$                  -$G_R$              t      **FIG 13**

$G_D$                                      t      **FIG 14**

$G_D$                                      t      **FIG 15**

$G_D$                                      t      **FIG 16**

S                                        t      **FIG 17**

B ... $G_D$ ... P

F   5

**FIG 18**

B ... GD ... P

**FIG 20**

FIG 19

FIG 21

FIG 22

FIG 29

RF ⸻ t   **FIG 23**

G$_S$ ⸻ -G$_S$ ⸺ G$_{SF}$ ⸻ t   **FIG 24**

G$_R$ ⸻ G$_{RF}$ ⸺ -G$_R$ ⸻ t   **FIG 25**

G$_D$ ⸻ t   **FIG 26**

G$_D$ ⸻ t   **FIG 27**

S ⸻ t   **FIG 28**